# FASCICULE DE BREVET EUROPEEN

(11) **EP 4 537 037 B1**
(45) Date de publication et mention de la délivrance du brevet: **08.04.2026**
(21) Numéro de dépôt: 23728756.0
(22) Date de dépôt: 25.05.2023
(51) Int. Cl.: F27B 5/14, F27D 11/00, F27D 99/00, H01L 21/67, F27B 17/00, H05B 3/00, H05B 3/06

(54) **SUPPORT DE LAMPES À HAUTE INTENSITÉ POUR FOUR À RECUIT THERMIQUE RAPIDE**
HALTERUNG FÜR HOCHLEISTUNGSLAMPEN FÜR EINEN SCHNELLGLÜHOFEN
HOLDER FOR HIGH-INTENSITY LAMPS FOR A RAPID THERMAL ANNEALING FURNACE

(30) Priorité: 10.06.2022 FR 2205604
(43) Date de publication de la demande: 16.04.2025
(73) Titulaire: Annealsys, 34000 Montpellier (FR)
(72) Inventeur: DUCRET, René-Pierre, 34000 MONTPELLIER (FR)
(74) Mandataire: Cabinet Beaumont
(86) Numéro de dépôt international: PCT/EP2023/064106
(87) Numéro de publication internationale: WO 2023/237351

(56) Documents cités:
- WO-A1-2016/064833
- US-A- 5 054 107
- US-A1- 2021 398 830
- US-B2- 8 698 049

## Description

La présente demande de brevet revendique la priorité de la demande de brevet français FR22/05604 qui sera considérée comme faisant partie intégrante de la présente description.

### Domaine technique

La présente description concerne de façon générale les supports de lampes à haute intensité pour fours à recuit thermique rapide et les fours à recuit thermique rapide comprenant de tels supports.

### Technique antérieure

Un four à recuit thermique rapide est un four permettant de porter un objet, notamment un substrat de silicium, à haute température, par exemple jusqu'à 1200 °C ou plus, dans un temps très court, en général quelques secondes.

De telles montées en température sont obtenues par des lampes à haute intensité ou par chauffage laser. Dans le cas de lampes à haute intensité, notamment des lampes infrarouges, le four comprend un support des lampes. Le support comprend une paroi, faisant face aux lampes, adaptée à réfléchir le rayonnement émis par les lampes vers l'objet à chauffer. Il est en outre généralement nécessaire de prévoir un système de refroidissement du support, par exemple un système de circulation d'eau dans des conduites internes du support.

Il est connu de réaliser un support de lampes à haute intensité pour four à recuit thermique rapide avec des pièces en aluminium assemblées par vissage et refroidies par eau. Un inconvénient est que la circulation d'eau peut entraîner une corrosion de l'aluminium, et nécessiter des opérations de maintenance pour remplacer des pièces du support. Le document US 8 698 049 décrit un support pour lampes à haute intensité.

### Résumé de l'invention

Un objet d'un mode de réalisation est de prévoir un support de lampes à haute intensité pour four à recuit thermique rapide palliant tout ou partie des inconvénients des supports de lampes à haute intensité existants.

Un autre objet d'un mode de réalisation est que le procédé de fabrication du support à lampes à haute intensité est simple.

Un autre objet d'un mode de réalisation est que le coût de fabrication du support à lampes à haute intensité est réduit.

Un autre objet d'un mode de réalisation est que le coût de maintenance du support à lampes à haute intensité est réduit.

Un autre objet d'un mode de réalisation est que la support comprend une paroi adaptée à réfléchir le rayonnement émis par les lampes.

Un autre objet d'un mode de réalisation est que le support intègre des conduites pour la circulation d'un liquide de refroidissement.

Un mode de réalisation prévoit un support pour lampes à haute intensité comprenant :
- une première pièce en un premier matériau, destinée à supporter les lampes à haute intensité et comprenant une face destinée à être en regard des lampes à haute intensité ;
- une deuxième pièce en un deuxième matériau, différent du premier matériau, recouvrant la première pièce et fixée à la première pièce ; et
- une feuille, en un troisième matériau différent du premier matériau, interposée entre la première pièce et la deuxième pièce et délimitant avec la deuxième pièce au moins une cavité destinée à contenir un liquide de refroidissement.

Selon un mode de réalisation, les deuxième et troisième matériaux sont inoxydables.

Selon un mode de réalisation, les deuxième et troisième matériaux sont moins bon conducteurs de la chaleur que le premier matériau.

Selon un mode de réalisation, le premier matériau est compris dans le groupe comprenant l'aluminium, le cuivre et les alliages de cuivre comme le laiton.

Selon un mode de réalisation, le deuxième matériau est compris dans le groupe comprenant l'acier inoxydable, les plastiques résistants à des températures supérieures à 100 °C, et les matériaux composites résistants à des températures supérieures à 100 °C.

Selon un mode de réalisation, le troisième matériau est compris dans le groupe comprenant l'acier inoxydable, le cuivre et les alliages de cuivre comme le laiton.

Selon un mode de réalisation, l'épaisseur de la feuille est comprise entre 0,03 mm et 0,3 mm.

Un mode de réalisation prévoit également un four à recuit thermique rapide comprenant des lampes à haute intensité et un support desdites lampes à haute intensité tel que défini précédemment.

Selon un mode de réalisation, les lampes à haute intensité sont des lampes infrarouges.

Selon un mode de réalisation, le four comprend un système de mise en circulation du liquide de refroidissement dans la cavité.

Selon un mode de réalisation, le liquide de refroidissement comprend de l'eau.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et très schématique, d'un exemple de four à recuit thermique rapide ;
la figure 2 est une vue en coupe, partielle et schématique, d'un exemple de support de lampes à haute intensité pour four à recuit thermique rapide ;
la figure 3 est une vue en coupe, partielle et schématique, d'un mode de réalisation d'un support de lampes à haute intensité pour four à recuit thermique rapide ; et
la figure 4 est une vue éclatée du mode de réalisation du support de la figure 3.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés.

Sauf précision contraire, les expressions "environ", "approximativement", "sensiblement", et "de l'ordre de" signifient à 10 % près, de préférence à 5 % près. Sauf précision contraire, les adjectifs numéraux ordinaux, tels que "premier", "deuxième", etc., sont utilisés seulement pour distinguer des éléments entre eux. En particulier, ces adjectifs ne limitent pas les modes de réalisation décrits à un ordre particulier de ces éléments.

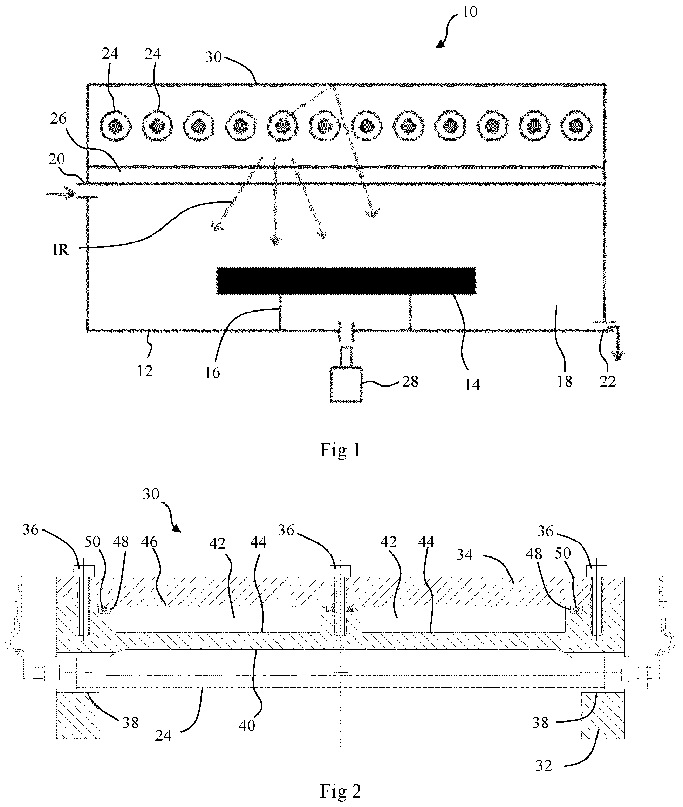

La figure 1 est une vue en coupe, partielle et schématique, d'un exemple de four 10 à recuit thermique rapide.

Le four 10 comprend une enceinte 12, également appelée réacteur, dans laquelle est placé l'objet 14 à traiter qui est disposé sur un reposoir 16. L'objet 14 à traiter est par exemple un substrat de silicium. Un gaz inerte peut être injecté dans le volume interne 18 du réacteur 12 par un système d'injection 20. Le volume interne 18 du réacteur 12 peut être maintenu à basse pression grâce à un système de pompage 22. L'objet 14 à traiter est chauffé par le rayonnement émis par des lampes 24 à haute intensité maintenues par un support 30. Les lampes 24 à haute intensité sont par exemple des lampes infrarouges.

Un hublot en quartz 26 assure l'étanchéité du volume interne 18 du réacteur 12 tout en laissant passer le rayonnement IR émis par les lampes 24. Le support 30 est en outre adapté à renvoyer vers le hublot 26 le rayonnement IR émis par les lampes 24. Les parois du réacteur 12 sont refroidies notamment pour éviter de contaminer le substrat 14 et protéger les équipements de commande et/ou de mesure équipant le réacteur 12. La température du substrat 14 peut être contrôlée par un régulateur relié à un pyromètre 28.

La figure 2 est une vue en coupe, partielle et schématique, d'un exemple du support 30 des lampes 24, une seule lampe 24 étant visible en figure 2. Le plan de coupe de la figure 2 est orthogonal au plan de coupe de la figure 1. Le support 30 est composé d'une première pièce 32 et d'une deuxième pièce 34, fixées l'une à l'autre au moyen de vis 36. De préférence, il n'y a pas de soudures entre la première pièce 32 et la deuxième pièce 34.

Les lampes 24 sont fixées à la première pièce 32. La première pièce 32 comprend par exemple, pour chaque lampe 24, deux ouvertures 38 dans lesquelles sont logées les extrémités de la lampe 24. La première pièce 32 comprend une paroi 40 faisant face aux lampes 24 et qui forme un miroir réfléchissant le rayonnement émis par les lampes 24.

Lorsque les pièces 32 et 34 sont assemblées, elles délimitent des cavités internes 42 dans lesquelles un liquide de refroidissement, par exemple de l'eau, est mis en circulation. Les cavités internes 42 peuvent être délimitées par des enfoncements 44 prévus dans la première pièce 32 qui sont obturés par une face plane 46 de la deuxième pièce 34, lorsque la deuxième pièce 34 est assemblée à la première pièce 32.

La première pièce 32 peut comprendre des rainures 48 du côté de la deuxième pièce 34. L'étanchéité des cavités internes 42 peut être obtenue par des joints toriques 50 disposés dans les rainures 48.

Lorsque les lampes 24 sont des lampes infrarouges, les pièces 32 et 34 peuvent être réalisées en aluminium qui est un matériau à faible coût, bon conducteur de la chaleur, et bon réflecteur du rayonnement infrarouge émis par les lampes 24.

Un inconvénient est que les pièces 32 et 34 peuvent se corroder au contact du liquide de refroidissement circulant dans les cavités 42 lorsque celui-ci comprend de l'eau. Une possibilité serait de prévoit un traitement anticorrosion sur les parois des cavités 42. Toutefois, ceci tend à rendre complexe le procédé de fabrication du support 30 et en augmente le coût de fabrication.

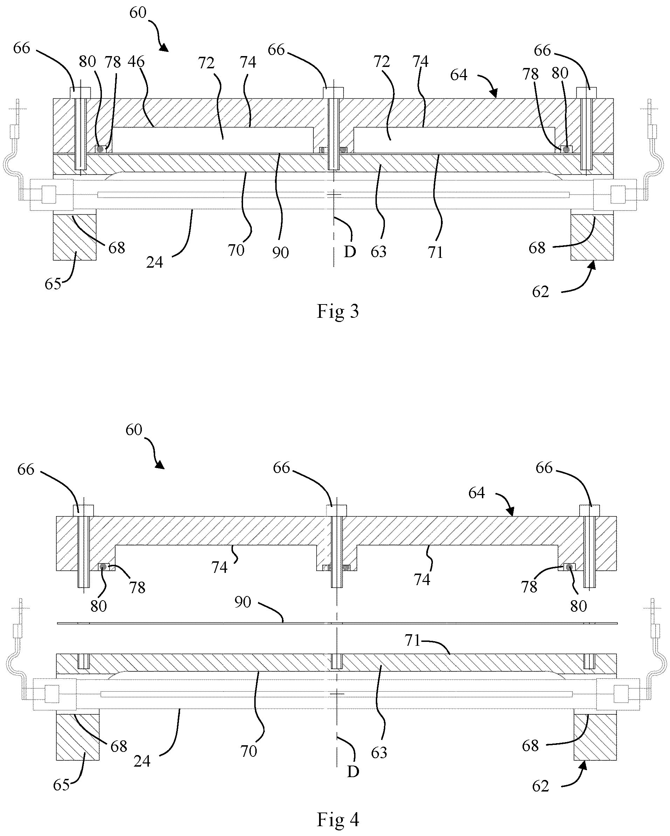

La figure 3 est une vue en coupe, partielle et schématique, d'un mode de réalisation d'un support 60 de lampes 24 pouvant être utilisé comme support 30 du four 1 représenté en figure 1. La figure 4 est une vue éclatée avec coupe du mode de réalisation du support 60 de la figure 3. Le plan de coupe des figures 3 et 4 est orthogonal au plan de coupe de la figure 1. Une seule lampe 24 est visible sur les figures 3 et 4.

Le support 60 comprend un empilement d'une première pièce 62, d'une feuille 90 et d'une deuxième pièce 64, fixées les unes aux autres au moyen de vis 66, trois vis étant représentées à titre d'exemple sur les figures 3 et 4. La feuille 90 est prise en sandwich entre la première pièce 62 et la deuxième pièce 64. De préférence, il n'y a pas de soudures entre la première pièce 62, la deuxième pièce 64, et la feuille 90.

La première pièce 62 comprend une partie 63, de section droite généralement carrée ou rectangulaire, d'axe central D, se prolongeant par un rebord périphérique 65 qui s'étend du côté opposé à la deuxième pièce 64. Les lampes 24 sont fixées au rebord 65 de la première pièce 62. Le rebord 65 de la première pièce 62 comprend par exemple, pour chaque lampe 24, deux ouvertures 68 dans lesquelles sont logées les extrémités de la lampe 24. La première pièce 62 comprend une paroi 70 faisant face aux lampes 24 et qui forme un miroir réfléchissant le rayonnement émis par les lampes 24. Selon un mode de réalisation, la paroi 70 comprend une zone plane et de forme carrée ou rectangulaire au niveau de la partie centrale 63 de la première pièce 62, et comprend des zones carrées ou rectangulaires au niveau du rebord 65. La première pièce 62 comprend une face 71 située du côté de la feuille 90 et contre laquelle la feuille 90 est appliquée lorsque la première pièce 62, la feuille 90 et la deuxième pièce 64 sont fixées les unes aux autres au moyen des vis 66. Selon un mode de réalisation, la face 71 est plane et la feuille 90 est plane. Selon un mode de réalisation, la face 71 est de forme carrée ou rectangulaire.

Lorsqu'elles sont assemblées, les pièces 62, 64 et la feuille 90 délimitent des cavités internes 72 dans lesquelles un liquide de refroidissement, par exemple de l'eau contenant éventuellement des additifs, est mis en circulation en fonctionnement. Les cavités internes 72 sont délimitées par des enfoncements 74 prévus dans la deuxième pièce 64 qui sont obturés par la feuille 90, lorsque la deuxième pièce 64 est assemblée à la première pièce 62 avec interposition de la feuille 90. La deuxième pièce 64 comprend des rainures 78 du côté de la première pièce 62. L'étanchéité des cavités internes 72 peut être obtenue par des joints toriques 80 disposés dans les rainures 78.

La première pièce 62 est réalisée en un premier matériau. Selon un mode de réalisation, le premier matériau est compris dans le groupe comprenant l'aluminium, les alliages d'aluminium ayant une bonne aptitude au polissage mécanique miroir, le cuivre et les alliages de cuivre comme le laiton. La surface 70 formant un miroir au rayonnement des lampes 24 peut être obtenue de façon simple par polissage mécanique sans qu'il soit nécessaire de prévoir le dépôt d'un revêtement réfléchissant sur la surface 70. Selon un mode de réalisation, la rugosité Ra de la surface 70 est inférieure à 0,2. Selon un mode de réalisation, la surface 70 réfléchit plus de 90 % du rayonnement émis par les lampes 24. Selon un mode de réalisation, le rayonnement émis par les lampes 24 a une longueur d'onde comprise entre 0,5 µm et 4 µm, de préférence avec un pic d'émission à 1 µm pour une température de filament de 2500 K.

L'épaisseur moyenne de la première pièce 62 dans les parties en regard des cavités 72 est comprise entre 4 mm et 8 mm. Selon un mode de réalisation, l'épaisseur du rebord périphérique 65 de la première pièce 62, mesurée selon l'axe D, est compris entre 10 mm et 20 mm. Comme le premier matériau est un bon conducteur de la chaleur, il permet une évacuation efficace vers le liquide de refroidissement de la chaleur transmise à la première pièce 62 par les lampes 24 sans qu'il soit nécessaire de prévoir des cavités pour la circulation du liquide de refroidissement directement dans le rebord 65 de la première pièce 62.

La deuxième pièce 64 est réalisée en un deuxième matériau différent du premier matériau. Le deuxième matériau est inoxydable. Le deuxième matériau peut être moins bon conducteur de la chaleur que le premier matériau. Selon un mode de réalisation, le deuxième matériau est compris dans le groupe comprenant l'acier inoxydable, les plastiques résistants à des températures supérieures à 100 °C, notamment les thermoplastiques à base de polyoxyméthylène, et les matériaux composites résistants à des températures supérieures à 100 °C. La profondeur de chaque enfoncement 74, mesurée selon l'axe D, peut être comprise entre 5 mm et 10 mm.

La feuille 90 est en un troisième matériau différent du premier matériau et éventuellement identique au deuxième matériau. Le troisième matériau est inoxydable. Le troisième matériau peut être moins bon conducteur de la chaleur que le premier matériau, mais est de préférence métallique pour assurer une conduction de la chaleur suffisante. Selon un mode de réalisation, le troisième matériau est compris dans le groupe comprenant l'acier inoxydable, le cuivre et les alliages de cuivre comme le laiton. Selon un mode de réalisation, l'épaisseur de la feuille 90 est inférieure à 0,5 mm, de préférence comprise entre 0,03 mm et 0,3 mm. L'épaisseur réduite de la feuille 90 permet de la déformer facilement.

Selon un mode de réalisation, la feuille 90 recouvre complètement la face 71 de la première pièce 62. Dans le cas où la face 71 correspond à un carré ou à un rectangle, la feuille 90 correspond à un carré ou à un rectangle de même surface.

En fonctionnement, le liquide de refroidissement est en contact seulement avec des matériaux inoxydables. Ceci permet, de façon avantageuse d'empêcher la corrosion du support 60, notamment lorsque le liquide de refroidissement est à base d'eau. En outre, il n'est pas nécessaire de prévoir un traitement anticorrosion sur les parois des cavités 72. Le procédé de fabrication du support 60 reste donc simple.

En fonctionnement, le liquide de refroidissement présent dans les cavités 72 est sous pression et maintient la feuille 90 en appui contre la première pièce 62. On obtient ainsi un contact direct entre la feuille 90 et la première pièce 62 sensiblement sans interposition d'un film d'air. On obtient donc une bonne transmission de chaleur entre la première pièce 62 et la feuille 90. Selon un mode de réalisation, la pression du liquide de refroidissement dans les cavités 72 est comprise entre 0,1 MPa et 0,5 MPa, de préférence entre 0,3 MPa et 0,4 MPa. En outre, vu l'épaisseur réduite de la feuille 90, même si la feuille 90 est en un troisième matériau moins bon conducteur de la chaleur que le premier matériau composant la première pièce 62, le troisième matériau étant néanmoins de préférence métallique, la conduction de la chaleur entre la première pièce 62 et le liquide de refroidissement au travers de la feuille 90 de très fine épaisseur est suffisamment efficace pour permettre un refroidissement convenable de la première pièce 62 en fonctionnement.

Divers modes de réalisation et variantes ont été décrits .

Enfin, la mise en oeuvre pratique des modes de réalisation et variantes décrits est à la portée de l'homme du métier à partir des indications fonctionnelles données ci-dessus.

## Revendications

1. Support (60) pour lampes à haute intensité (24) comprenant :
- une première pièce (62) en un premier matériau, destinée à supporter les lampes à haute intensité et comprenant une face (70) destinée à être en regard des lampes à haute intensité ;
- une deuxième pièce (64) en un deuxième matériau, différent du premier matériau, recouvrant la première pièce et fixée à la première pièce ; et
- une feuille (90), en un troisième matériau différent du premier matériau, interposée entre la première pièce et la deuxième pièce et délimitant avec la deuxième pièce au moins une cavité (72) destinée à contenir un liquide de refroidissement.

2. Support selon la revendication 1, dans lequel les deuxième et troisième matériaux sont inoxydables.

3. Support selon la revendication 1 ou 2, dans lequel les deuxième et troisième matériaux sont moins bon conducteurs de la chaleur que le premier matériau.

4. Support selon l'une quelconque des revendications 1 à 3, dans lequel le premier matériau est compris dans le groupe comprenant l'aluminium, le cuivre et les alliages de cuivre comme le laiton.

5. Support selon l'une quelconque des revendications 1 à 4, dans lequel le deuxième matériau est compris dans le groupe comprenant l'acier inoxydable, les plastiques résistants à des températures supérieures à 100 °C, et les matériaux composites résistants à des températures supérieures à 100 °C.

6. Support selon l'une quelconque des revendications 1 à 5, dans lequel le troisième matériau est compris dans le groupe comprenant l'acier inoxydable, le cuivre et les alliages de cuivre comme le laiton.

7. Support selon l'une quelconque des revendications 1 à 6, dans lequel l'épaisseur de la feuille (90) est comprise entre 0,03 mm et 0,3 mm.

8. Four à recuit thermique rapide comprenant des lampes à haute intensité (24) et un support (60) desdites lampes à haute intensité selon l'une quelconque des revendications 1 à 7.

9. Four à recuit thermique rapide selon la revendication 8, dans lequel les lampes à haute intensité (24) sont des lampes infrarouges.

10. Four à recuit thermique rapide selon la revendication 8 ou 9, comprenant un système de mise en circulation du liquide de refroidissement dans la cavité (72).

11. Four à recuit thermique rapide selon la revendication 8, dans lequel le liquide de refroidissement comprend de l'eau.

## Patentansprüche

1. Halter (60) für Hochintensitätslampen (24), der folgendes aufweist:
einen ersten Teil (62) aus einem ersten Material, zum Tragen der Hochintensitätslampen vorgesehen und eine Oberfläche (70) aufweisend,
die den Hochintensitätslampen zugewandt vorgesehen ist;
einen zweiten Teil (64) aus einem zweiten Material, verschieden von dem ersten Material, der den ersten Teil bedeckt und an dem ersten Teil befestigt ist; und
ein Blech (90), aus einem dritten Material verschieden von dem ersten Material, zwischen dem ersten Teil und dem zweiten Teil angeordnet und
mit dem zweiten Teil wenigstens einen Hohlraum (72) abgrenzend, zum Enthalten eines Kühlmittels vorgesehen.

2. Halter nach Anspruch 1, wobei das zweite und dritte Material rostfrei sind.

3. Halter nach Anspruch 1 oder 2, wobei das zweite und dritte Material schlechtere Wärmeleiter als das erste Material sind.

4. Halter nach einem der Ansprüche 1 bis 3, wobei das erste Material in der Gruppe enthalten ist, die Aluminium, Kupfer und Kupferlegierungen wie Messing aufweist.

5. Halter nach einem der Ansprüche 1 bis 4, wobei das zweite Material in der Gruppe enthalten ist, die rostfreien Stahl, Kunststoffe resistent gegen Temperaturen höher als 100°C und Verbundmaterialien resistent gegen Temperaturen höher als 100°C aufweist.

6. Halter nach einem der Ansprüche 1 bis 5, wobei das dritte Material in der Gruppe enthalten ist, die rostfreien Stahl, Kupfer und Kupferlegierungen wie Messing aufweist.

7. Halter nach einem der Ansprüche 1 bis 6, wobei die Dicke des Blechs (90) im Bereich von 0,03 mm bis 0,3 mm liegt.

8. Schnelltemperglühofen, der folgendes aufweist: Hochintensitätslampen (24) und einen Halter (60) für die Hochintensitätslampen nach einem der Ansprüche 1 bis 7.

9. Schnelltemperglühofen nach Anspruch 8, wobei die Hochintensitätslampen (24) Infrarotlampen sind.

10. Schnelltemperglühofen nach Anspruch 8 oder 9, der folgendes aufweist: ein System zum Zirkulieren des Kühlmittels in dem Hohlraum (72).

11. Schnelltemperglühofen nach Anspruch 8, wobei das Kühlmittel Wasser aufweist.

## Claims

1. Holder (60) for high-intensity lamps (24) comprising:
- a first part (62) made of a first material, intended to support the high-intensity lamps and comprising a surface (70) intended to face the high-intensity lamps;
- a second part (64) made of a second material, different from the first material, covering the first part and attached to the first part; and
- a sheet (90), made of a third material different from the first material, interposed between the first part and the second part and delimiting with the second part at least one cavity (72) intended to contain a coolant.

2. Holder according to claim 1, wherein the second and third materials are stainless.

3. Holder according to claim 1 or 2, wherein the second and third materials are poorer heat conductors than the first material.

4. Holder according to any of claims 1 to 3, wherein the first material is comprised in the group comprising aluminum, copper, and copper alloys such as brass.

5. Holder according to any of claims 1 to 4, wherein the second material is comprised in the group comprising stainless steel, plastics resistant to temperatures higher than 100°C, and composite materials resistant to temperatures higher than 100°C.

6. Holder according to any of claims 1 to 5, wherein the third material is comprised in the group comprising stainless steel, copper, and copper alloys such as brass.

7. Holder according to any of claims 1 to 6, wherein the thickness of the sheet (90) is in the range from 0.03 mm to 0.3 mm.

8. Rapid thermal annealing furnace comprising high-intensity lamps (24) and a holder(60) for said high-intensity lamps according to any of claims 1 to 7.

9. Rapid thermal annealing furnace according to claim 8, wherein the high-intensity lamps (24) are infrared lamps.

10. Rapid thermal annealing furnace according to claim 8 or 9, comprising a system for circulating the coolant in the cavity (72).

11. Rapid thermal annealing furnace according to claim 8, wherein the coolant comprises water.
